# EUROPEAN PATENT APPLICATION

(11) **EP 4 580 341 A2**
(43) Date of publication of application: **02.07.2025**
(21) Application number: 24210829.8
(22) Date of filing: 05.11.2024
(51) Int. Cl.: H10D 84/01, H10D 30/01, H10D 30/00, H10D 84/83, H10D 64/27

(54) **DIRECTED SELF ASSEMBLY-ENABLED BACK-SIDE CONTACT ARRAYS ALIGNED TO GATE ELECTRODES**

(30) Priority: 29.12.2023 US 202318400794
(71) Applicant: INTEL Corporation, Santa Clara, CA 95054 (US)
(72) Inventor: Mannebach, Ehren, Beaverton, 97007 (US); Mills, Shaun, Hillsboro, 97123 (US); D'Silva, Joseph, Hillsboro, 97124 (US); Kobrinsky, Mauro, Portland, 97229 (US); Desai, Umang, Portland, 97225 (US)
(74) Representative: Goddar, Heinz J.

(57) **Abstract**

Transistor structures between and coupled to front- and back-side interconnect layers may have precisely aligned arrays of contacts and dielectric structures over and under the transistor structures. Transistor structures may have a gate electrode thickness under a channel region one-and-a-half or two times greater than a thickness between adjacent nanoribbons in the channel region. Front- and back-side spacer layers with a same composition may have a discernible interface. Contacts and dielectric structures on a back side may be formed using directed self-assembly of sacrificial materials aligned to gate electrodes revealed on a substrate back side.

## Description

### BACKGROUND

Formation of back-side contacts and/or gate vias is limited, sometimes severely, by edge placement errors between back-side patterns and front-side features. Typical patterning misalignments may be dwarfed by wafer distortions at least along certain orientations. Such misalignments may significantly degrade integrated circuit (IC) device performance or prevent further down-scaling of transistor arrays.

New techniques, structures, and materials are needed to improve front- and back-side feature alignments.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIG. 1 is a flow chart of methods for forming an array of back-side contacts and dielectric structures aligned with transistor gate electrodes, in accordance with some embodiments;
FIGS. 2, 3, 4, 5, 6, 7, 8, and 9 illustrate cross-sectional profile views of transistor structures between and coupled to front- and back-side interconnect layers, at various stages of manufacture, in accordance with some embodiments;
FIGS. 10A and 10B illustrate cross-sectional profile views of an integrated circuit (IC) device having transistor structures between and coupled to front- and back-side layers in frontand back-side interconnect networks, in accordance with some embodiments;
FIG. 11 illustrates a cross-sectional profile view of an IC system having transistor structures with front- and back-side contacts and vias to front- and back-side interconnect layers, in accordance with some embodiments;
FIG. 12 illustrates a diagram of an example data server machine employing an IC device having back-side contacts through self-aligned dielectric layers, in accordance with some embodiments; and
FIG. 13 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Materials, structures, and techniques are disclosed to improve the alignment and scaling of integrated circuit (IC) devices having transistors between and coupled to front- and back-side interconnect networks.

Typical patterning methods may be insufficiently precise to properly align front- and back-side features in IC devices, particularly given the nonstop scaling down of devices. A method is described to form back-side arrays of sacrificial materials precisely aligned to transistor structures formed on a front side. Directed self-assembly (DSA) may be used to form an array or grating of contacts and dielectric structures on a back side to precisely match a similar array on a front side. The DSA grating may be aligned with transistor gate electrodes revealed on the back side and allow for further self-aligned back-side contacts and vias. Self-alignment may be limited to a single, key dimension (e.g., parallel to a longitudinal direction of a channel region).

Such self-aligned features enable back-side interconnects with continued device scaling. In addition to near-perfect alignment between front- and back-side features (e.g., front- and backside spacer layers), described structures may include gate electrodes with thick bottoms to facilitate back-side reveal and subsequent alignment.

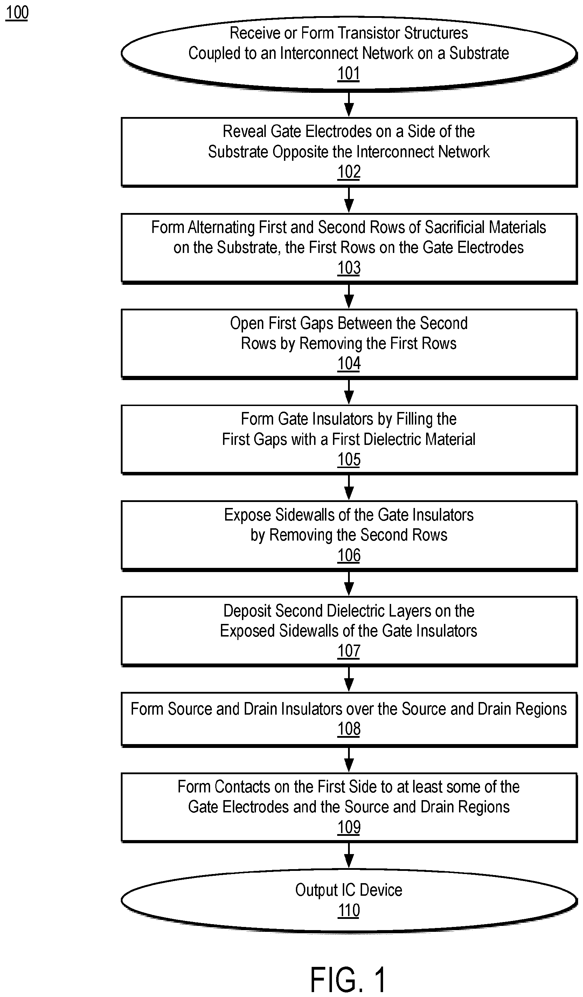

FIG. 1 is a flow chart of methods 100 for forming an array of back-side contacts and dielectric structures aligned with transistor gate electrodes, in accordance with some embodiments. Methods 100 include operations 101-110. Some operations shown in FIG. 1 are optional. Additional operations may be included. FIG. 1 shows an example sequence, but the operations can be done in other orders as well, and some operations may be omitted. Some operations can also be performed multiple times before other operations are performed. Some operations may be included within other operations so that the number of operations illustrated FIG. 1 is not a limitation of the methods 100.

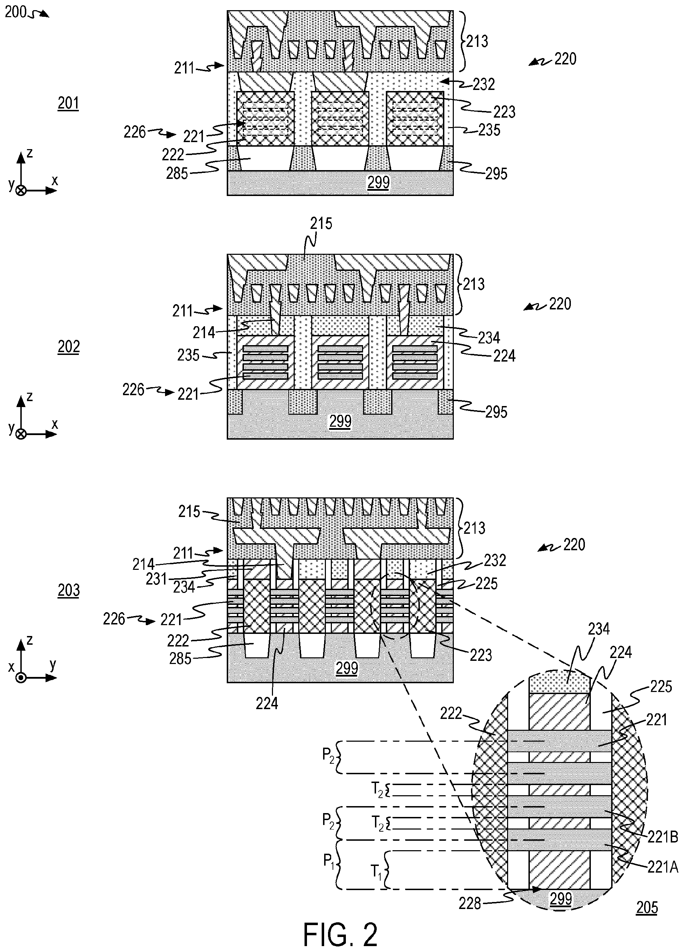

FIGS. 2, 3, 4, 5, 6, 7, 8, and 9 illustrate cross-sectional profile views of transistor structures between and coupled to front- and back-side interconnect layers, at various stages of manufacture, in accordance with some embodiments. FIGS. 2-9 show possible examples of intermediate structures during an embodiment of a practice of methods 100 of FIG. 1.

Returning to FIG. 1, methods 100 begin at operation 101 with receiving a substrate. In some embodiments, the substrate has multiple transistor structures (e.g., in extensive arrays), and the multiple transistor structures are coupled to an interconnect network (e.g., on a front side) over the transistor structures. The transistor structures each include channel regions between source and drain regions and gate electrodes over the channel regions and between the source and drain regions. The channels regions may be in any suitable structures, such as nanoribbons, fins, etc. Nanoribbons may be in a stack of mechanically and electrically parallel nanoribbons between the source and drain regions. Nanoribbons may be of any suitable width or length. Some nanoribbons may have dimensions fitting nanowires or nanosheets.

Notably, the gate electrode may be received (or formed) with an unconventional thickness of metal under a channel region. For example, in embodiments having channel regions in stacks of nanoribbons and extending through the gate electrodes, a lowest nanoribbon in a stack (e.g., opposite or away from an interconnect network over the transistor structures) may have a same thickness, or less, of metal opposite or away from an interconnect network as between adjacent nanoribbons. That is, a vertical pitch or distance between adjacent nanoribbons may determine a consistent thickness of metal between adjacent nanoribbons, and the lowest nanoribbon in a stack may have approximately the same thickness of metal under the lowest nanoribbon (e.g., away from the interconnect network and the other nanoribbons). In some embodiments described herein, a gate electrode has gate metal under the nanoribbon stack with a thickness of two or three times the thickness of gate metal between adjacent nanoribbons. Such a thickness may facilitate further processing operations, such as back-side processing operations, as described elsewhere herein. In some embodiments, a gate electrode has gate metal under the nanoribbon stack with a thickness of one-and-a-half times the thickness of gate metal between adjacent nanoribbons. Such a thickness may be sufficient to facilitate further processing operations, e.g., more tightly controlled operations (such as polishing or other planarizing or recessing processes) than those requiring larger thicknesses.

In some embodiments, the transistor structures are formed after receiving the substrate. In some such embodiments, the gate electrodes are formed over and around stacks of nanoribbons such that the nanoribbons extend through the gate electrodes. In some such embodiments, the forming the gate electrodes includes depositing a gate metal (e.g., on a substrate surface) to a first thickness between a surface of the gate electrodes and the lowest of the nanoribbons, nearest to the surface, and to a second thickness between the lowest of the nanoribbons and a next-lowest of the nanoribbons (e.g., next-nearest to the surface), and the first thickness is greater than one-and-a-half times the second thickness. In some embodiments, the first thickness is greater than two or three times the second thickness. The gate electrode surface under the nanoribbon stack may be at (e.g., interface with) the substrate surface that the gate metal is deposited on. The thickness of the gate metal between the surface and the nanoribbon may be set by any suitable means. In some embodiments, the dimension is set by a sacrificial material under the nanoribbon stack whose thickness (before removal of the sacrificial material) is the eventual thickness (once the sacrificial material is removed) of the gate metal under the stack. In some such embodiments, this same sacrificial material is utilized to set the pitch between adjacent nanoribbons and so the thickness of gate metal between adjacent nanoribbons.

The interconnect network may be or include one or more metallization layers. As used herein, the term "metallization layer" describes layers with interconnections or wires that provide electrical routing, generally formed of metal or other electrically conductive material. Adjacent metallization layers may be formed of different materials and by different methods. Adjacent metallization layers are interconnected by vias that may be characterized as part of the metallization layers or between the metallization layers. In some embodiments, front-side metallization layers are formed over and immediately adjacent transistor structures. Front-side metallization layers may include M0 (metal 0), V0 (via 0), M1, M2/V1, M3/V2, M4/V3, and M4-M12, or any number of metallization layers such as eight or more metallization layers. Metallization layers are embedded within dielectric materials, for example, with interconnected metal lines and vias extending through dielectric material.

Metallization layers may be formed by any suitable means and may include any suitable materials. In many embodiments, metallization layers are in interconnect structures having one or more of copper (Cu), tungsten (W), ruthenium (Ru), molybdenum (Mo), gold (Au), tantalum (Ta), cobalt (Co), aluminum (Al), and nickel (Ni), including in alloys. Metallization layers may include any of these or other metals. In some embodiments, metallization layers include nitrides of metals, e.g., tantalum and titanium (Ti). Metallization layers may include other electrically conductive materials, including non-metals. Metallization layers may be built up in a back-end-of-line (BEOL) process. Although metallization layers may be built up in a BEOL process in some exemplary embodiments, other means of forming metallization layers may be utilized.

The substrate may include any suitable material or materials. Any suitable semiconductor or other material can be used. The substrate may be any suitable substrate, such as a wafer, die, etc. The substrate may include a semiconductor material that transistors can be formed out of and on, including a crystalline material, such as monocrystalline or polycrystalline silicon (Si), germanium (Ge), silicon germanium (SiGe), a III-V alloy material (e.g., gallium arsenide (GaAs)), a silicon carbide (SiC), a sapphire (Al₂O₃), or any combination thereof. In some embodiments, the substrate includes crystalline silicon and subsequent components are also silicon. The substrate may be a silicon-on-insulator (SOI) substrate. One or more fins, nanoribbons, etc., of semiconductor material may be included in or on the substrate. The fin or fins may be of the same material as the substrate or formed, e.g., deposited, on the substrate. The substrate may also include semiconductor materials, metals, dielectrics, dopants, and other materials commonly found in IC substrates. In many embodiments, the received substrate includes metallization layers in an interconnect structure on one side (e.g., a front side), coupled to transistor structures, and a thickness of crystalline material (such as a semiconductor material) under the transistor structures (e.g., on a back side).

FIG. 2 illustrates transistor structures 220 coupled to a first metallization layer 211 in a workpiece or IC device 200, in accordance with some embodiments, for example, following a performance of receiving operation 101. Device 200 includes transistor structures 220 having channel regions 226 in stacks of nanoribbons 221. Channel regions 226 are between and coupling drain and source regions 222, 223. A gate electrode 224 is adjacent nanoribbons 221. Some features of this and other figures are simplified. Some materials and structures (such as various liner layers, gate dielectric layers, contact metals, etc.) are not shown. Any illustrated layouts or routing are for example only and do not necessarily correspond to actual circuit layouts.

FIG. 2 shows cross-sectional profile views 201, 202, 203 of IC device 200. Views 201, 202 have x-z viewing planes with view 201 through source or drain regions 222, 223 (between gate electrodes 224) and view 202 through gate electrodes 224 (between drain and source regions 222, 223). View 202 shows a transverse profile cut of channel regions 226 with nanoribbons 221 extending through gate electrode 224 in they direction. The viewing plane of view 201 is between ends of collinear nanoribbons 221, but the outlines of nanoribbons 221 (e.g., just behind the viewing plane) are shown with dashed lines (e.g., for illustrative purposes). View 203 shows a longitudinal profile cut of channel regions 226 with nanoribbons 221 extending in the y-directions between drain and source regions 222, 223.

Metallization layer 211 is over and coupled to transistor structures 220. For example, metallization layer 211 is over and coupled to some of drain and source regions 222, 223. Some of drain and source regions 222, 223 are not coupled to layer 211, but will be coupled to an interconnect layer and network opposite layer 211, e.g., a back-side interconnect layer and network. Metallization layer 211 is part of an interconnect or metallization network 213 over transistor structures 220, e.g., a front-side interconnect network 213. Metallization layers 211 and network 213 may be substantially as described at operation 101 of FIG. 1, e.g., including lines and vias of copper, tungsten, ruthenium, molybdenum, or other metals, and extending through dielectric materials 215. Material 215 may be any suitable (e.g., electrically insulating) material(s). In many embodiments, dielectric materials 215 includes silicon and oxygen (e.g., in an oxide of silicon, such as silicon dioxide, SiO₂). In some such embodiments, dielectric materials 215 also include nitrogen and/or carbon. Materials 215 may include distinct portions with differing compositions. In some embodiments, a bulk dielectric material 215 provides isolation between conductors in interconnect layers 211, and one or more liner dielectric materials 215 provide interfaces (e.g., between bulk material(s) 215 and conductors, between layers of bulk material(s) 215, such as etch stops, etc.).

Transistor structures 220 may be field-effect transistors (FETs) having channel regions 226 of any suitable structure coupling drain and source regions 222, 223, as shown in view 203. In some embodiments, as shown in FIG. 2, channel regions 226 include stacks of nanoribbons 221. In other embodiments, channel regions 226 include single nanoribbons 221 or stacks of nanoribbons 221 having more or fewer nanoribbons 221 (i.e., an arbitrary number of nanoribbons 221) than in the exemplary embodiment of FIG. 2. Although transistor structures 220 in FIG. 2 each have a stack of vertically aligned nanoribbons 221 with a same conductivity type (e.g., either n- or p-type conductivity), other embodiments deploy stacked transistor structures 220 with nanoribbons 221 of both conductivity types (e.g., in complementary FETs (CFETs) or forksheet FETs). In other embodiments, channel regions 226 may be in fins (e.g., in FinFETs) or any other suitable channel structure.

Channel regions 226 may be of any suitable material and composition for a channel of a transistor. In some examples, channel regions 226 are substantially silicon. In other embodiments, channel regions 226 include germanium (e.g., Si_{1-X}Ge_{X}, Ge_{1-X}Sn_{X}, or substantially pure Ge). In some embodiments, channel regions 226 include a transition metal and a chalcogen. The transition metal may be any transition metal such as any element of groups 4 through 11, the group 3 elements scandium and yttrium, and the inner transition metals (e.g., f-block lanthanide and actinide series). Notable transition metals are molybdenum and tungsten. The chalcogen may be sulfur, selenium, or tellurium. In still other embodiments, channel region 226 includes one or more metals and oxygen (i.e., metal oxide semiconductor), such as, but not limited to, indium, gallium zinc oxide (IGZO).

Channel regions 226 are advantageously crystalline. Although the crystalline semiconductor includes polycrystalline thin film material, channel regions 226 may be substantially monocrystalline. In some embodiments where channel region 226 is substantially pure silicon, the crystallinity of channel region 226 is cubic with a top surface having crystallographic orientation of (100), (111), or (110), for example. Other crystallographic orientations are also possible. Channel regions 226 may also be polycrystalline or amorphous, for example in certain metal chalcogen and/or metal oxide embodiments.

As illustrated in views 202, 203, transistor structure 220 includes gate electrode 224 adjacent channel region 226 and between drain and source regions 222, 223 as part of a gate structure. The gate structure includes at least gate electrode 224 and a gate dielectric (not shown) over channel region 226. Gate electrode 224 may include one or more gate metals, such as a liner metal and a bulk metal enclose by the liner metal. A gate metal liner may include multiple layers of liner metal, and a bulk metal may also include multiple metals. Gate metal(s) may be chosen due to a metal workfunction, which may have an effect on a transistor voltage threshold V_{TH}. Gate electrode 224 may include any of the metals previously described, e.g., for metallization layers 211 (such as tantalum, titanium, tungsten, etc.), and/or other metals (e.g., for workfunction considerations).

A gate contact or via 214 may connect and couple gate electrode 224 to layer 211. Contacts or vias (not shown) may couple a given gate electrode 224 to upper layer 211 but just in front of or behind the viewing plane of, e.g., view 203. Other gate electrodes 224 may be coupled to a metallization layer opposite metallization layer 211. Gate contact or via 214 may include any of the metals previously described, e.g., for metallization layers 211, such as tungsten, titanium, molybdenum, etc.

A gate structure includes a gate dielectric (not shown) between channel region 226 and a gate metal of gate electrode 224, e.g., to provide electrical insulation between channel region 226 and gate electrode 224 and to electrostatically control of transistor structure 220. For example, a gate dielectric between channel region 226 and gate electrode 224 might be shown as around nanoribbons 221 in view 202 and above and below nanoribbons 221 in view 203. A gate dielectric may have more than one layer and may be of any suitable material(s). The one or more layers of gate dielectric may include a silicon oxide (such as SiO₂), a silicon oxynitride, etc. Advantageously, the gate dielectric includes a high-permittivity ("high-K") dielectric, which may improve transconductance. For example, a high-K dielectric may result in increased conductance of transistor structure 220 (through channel region 226) for a given gate bias.

An upper gate layer 234 is on (e.g., in contact with) gate electrode 224, as shown in views 202, 203. Gate layer 234 is an insulator structure over gate electrode 224, between gate electrode 224 and upper metallization layer 211. Gate layer 234 is advantageously a low-K dielectric structure or layer, e.g., to minimize capacitances between electrode 224 and adjacent conductors, such as metallization layers 211. Gate layer 234 may include silicon (for example, in an oxide, nitride, carbide, etc., of silicon). Gate layer 234 advantageously has an etch selectivity with adjacent dielectric structures, such as dielectric structure 235 adjacent and between transistor structures 220 (as shown in views 201, 202). In many embodiments, gate layer 234 includes silicon and nitrogen.

Drain and source regions 222, 223 are electrically and physically coupled to opposite ends of channel regions 226. Drain and source regions 222, 223 are impurity doped regions., e.g., regions of semiconductor material doped with one or more electrically active impurities and having increased charge-carrier availabilities and associated conductivities. Drain and source regions 222, 223 may be doped with an opposite type (e.g., n- or p-type) or of similar type to channel region 226. Drain and source regions 222, 223 may include a predominant semiconductor material, and one or more n-dopants (such as phosphorus, arsenic, or antimony) or p-type impurities (such as boron or aluminum). Other dopant materials may be used. Any suitable means of formation may be used. Regions 222, 223 may be epitaxially grown semiconductor regions, for example, of a Group IV semiconductor material (e.g., Si, Ge, SiGe, GeSn alloy). Other semiconductor materials may be employed. Regions 222, 223 are substantially crystalline. Drain and source regions 222, 223 may be polycrystalline or substantially monocrystalline, e.g., having long-range order at least adjacent ends of channel regions 226 and merging or joining into a unitary body with few grain boundaries.

In many embodiments, transistor structures 220 are physically symmetrical about channel regions 226 and gate electrode 224, and identifiers drain and source regions 222, 223 may be reversed interchangeably in many contexts. However, the classification of drain and source regions 222, 223 may be by the electrical relationships of transistor structure 220 and regions 222, 223 to other components in a given circuit (e.g., and the consequent direction of current flow through structure 220 and regions 222, 223). In some embodiments, at least some drain regions 222 are coupled to an upper metallization layer 211, and at least some source regions 223 are coupled to a lower metallization layer, opposite an upper metallization layer 211.

Drain and source regions 222, 223 may be separated from gate electrodes 224 by gate spacer layers 225 between gate electrode 224 and regions 222, 223. In many embodiments, gate spacer layers 225 are in contact with gate electrode 224 and regions 222, 223. Gate spacer layers 225 extend above the tops of gate electrode 224 and are in contact with upper gate layers 234, as shown in view 203. Gate spacer layers 225 are layers of insulator material, advantageously of low-K dielectric material, e.g., to minimize capacitances between electrode 224 and adjacent conductors, such as region 222, 223. Gate spacer layer 225 may include silicon (for example, in an oxide, nitride, carbide, etc., of silicon). Gate spacer layer 225 advantageously has an etch selectivity with adjacent dielectric structures, such as layer 234, dielectric structure 235, etc. In many embodiments, gate spacer layer 225 includes silicon, oxygen, carbon, and nitrogen.

Gate spacer layers 225 are also between upper gate layers 234 and dielectric structures 232, which are over drain and source regions 222, 223. Dielectric structures 232 may be similar to gate layers 234, but as insulator structures 232 over regions 222, 223 rather than gate electrode 224. Insulator structures 232 are between drain and source regions 222, 223 and upper metallization layer 211. Structure 232 is advantageously a low-K dielectric structure or layer, e.g., to minimize capacitances between regions 222, 223 and adjacent conductors, such as metallization layers 211. Dielectric structure 232 may include silicon (for example, in an oxide, nitride, carbide, etc., of silicon). Dielectric structure 232 advantageously has an etch selectivity with adjacent dielectric structures, such as layers 225, 234. In some embodiments, insulator structures 232 have a same composition, and are continuous with, dielectric structure 235 adjacent and between transistor structures 220, as shown in view 201.

Dielectric structures 235 are between transistor structures 220, for example, between gate electrodes 224 and between drain and source regions 222, 223. Dielectric structures 235 isolate adjacent transistor structures 220 and advantageously include a low-K dielectric material. Dielectric structures 235 may include silicon (for example, in an oxide, nitride, carbide, etc., of silicon). In many embodiments, dielectric structures 235 include silicon and oxygen.

Some drain and source regions 222, 223 are coupled to metallization layer 211 by vias or contacts 231 on and over regions 222, 223. Drain and source regions 222, 223 not contacted by vias or contacts 231 may be coupled to a metallization layer opposite metallization layer 211. Contacts 231 are through dielectric structures 232 or in place of dielectric structures 232 over regions 222, 223. Contacts 231 are metal structures that couple transistor structure 220 to interconnect layers 211. In some embodiments, additional metallization structures (not shown) couple contacts 231 to layer 211. For example, drain and source contact vias may couple with contacts 231 and layer 211 in a plane behind or in front of the plane of view 203. In some embodiments, contacts 231 directly contact layer 211, e.g., much like via 214 couples gate electrode 224 to interconnect layer 211. In some embodiments, one or more additional metallization structures (not shown) are between contact 231 and layer 211, and the structure(s) couple contact 231 to layer 211. Drain and source contacts 231 may include any of the metals previously described, e.g., for metallization layers 211, such as tungsten, titanium, molybdenum, etc.

Substrate 299 may be much as described of the substrate at operation 101 of FIG. 1, for example, including a crystalline material, as well as metals, dielectrics, dopants, and other materials commonly found in IC substrates. In the exemplary embodiment of FIG. 2, substrate 299 includes a substantially monocrystalline silicon base under transistor structures 220 and metallization layer 211, etc. Substrate 299 may be built up from a crystalline base to include any subsequently added materials and structures, such as transistor structures 220, dielectrics and metals in layer 211, etc. The thickness of the crystalline base, e.g., on a backside of transistor structures 220 may be much thicker (e.g., tens of microns) than the height or thickness of transistor structures 220 between the crystalline base and metallization layer 211.

Dielectric structures 285 are under regions 222, 223, e.g., between crystalline base material in both the x- and y-directions. Dielectric structures 285 are isolation structures on regions 222, 223 and may be of a fill material, e.g., filling an opening formed when cutting a semiconductor fin into separate channel regions 226. Dielectric structures 285 may be of any suitable material. In some embodiments, structures 285 include silicon (for example, in an oxide, nitride, carbide, etc., of silicon). In some embodiments, dielectric structures 285 have a same or similar composition as gate spacer layer 225. In some embodiments, structures 285 include silicon, oxygen, carbon, and nitrogen.

Isolation structures 295 are between adjacent dielectric structures 285 and between adjacent subfins (under gate electrodes 224). Isolation structures 295 may be shallow-trench isolation (STI) structures 295 and may have a composition similar to dielectric materials 215 or structures 235. Isolation structures 295 may include silicon (for example, in an oxide, nitride, carbide, etc., of silicon). In many embodiments, isolation structures 295 include silicon and oxygen.

Expanded view 205 shares the viewing plane of view 203 and provides more detail about the pitches of nanoribbons 221 and related metal thicknesses of gate electrode 224. A lowest surface 228 of gate electrode 224 is under nanoribbons 221. The lowest surface 228 of gate electrode 224 is furthest from front-side layers 211 and nearest a back-side of substrate 299. In the exemplary embodiment of FIG. 2, a first vertical pitch P₁ between lowest surface 228 under nanoribbons 221 and a lowest of the nanoribbons 221A is greater than twice a second vertical pitch P₂ between the lowest of the nanoribbons 221A and a next lowest of the nanoribbons 221B. Such a relatively large metal thickness under lowest nanoribbon 221A may be greater than in typical gate electrodes. The increased thickness provides more margin for back-side reveal processes. In some embodiments, the second vertical pitch P₂ between the lowest and next lowest nanoribbons 221A, 221B is 10 nm or less. In some embodiments, the first vertical pitch P₁ between lowest surface 228 and the lowest of the nanoribbons 221A is 20 nm or more. In some embodiments, the first vertical pitch P₁ between lowest surface 228 and the lowest of the nanoribbons 221A is 30 nm. In some embodiments, the first vertical pitch P₁ between lowest surface 228 and the lowest of the nanoribbons 221A is approximately 15 nm, greater than one-and-a-half times the second vertical pitch P₂ between the lowest and next lowest nanoribbons 221A, 221B. Such a pitch P₁ between lowest surface 228 and lowest nanoribbon 221A may be sufficient to facilitate back-side processing, e.g., employing more tightly controlled polishing or other reveal operations than those requiring larger thicknesses.

Similar relationships may be defined more directly by the metal thicknesses T₁, T₂ of gate electrode 224. In some embodiments, metal thickness T₁ between lowest surface 228 and the lowest of the nanoribbons 221A is greater than 1.5 times thickness T₂ between nanoribbons 221A, 221B. In some embodiments, metal thickness T₁ between lowest surface 228 and the lowest of the nanoribbons 221A is greater than two times thickness T₂ between nanoribbons 221A, 221B. For example, thickness T₂ between nanoribbons 221A, 221B may be about 8 nm, and thickness T₁ between lowest surface 228 and the lowest of the nanoribbons 221A may be about 17 nm.

Returning to FIG. 1, methods 100 continue with revealing multiple gate electrodes on a side of the substrate opposite the metallization network at operation 102. The revealing may be by any suitable means. An interconnect network may be on the top or front side of the substrate, and transistor structures coupled to the interconnect network may be covered by a significant thickness of crystalline (e.g., semiconductor) material on the back side of the substrate. In many embodiments, the substrate is coupled (e.g., bonded) to a carrier substrate and inverted (e.g., flipped over), and the substrate is recessed down to a back side of the gate electrodes. In some such embodiments, the substrate is a wafer, and the carrier substrate is a carrier wafer. In some embodiments, at least some of the recessing is by grinding. In some such embodiments, after grinding, the revealing of the transistor structures and gate electrodes is by polishing (or planarizing, e.g., chemical-mechanical polishing (CMP)). Such a polishing operation may be through crystalline and dielectric materials and endpoint on the metal of the gate electrodes once revealed.

In some embodiments, the gate electrode is received or formed with an unconventionally thick bottom metal under the channel region, for example, to facilitate the back-side recessing to the gate electrode bottom. Revealing a back side of the gate electrodes on a back side of the substrate exposes the bottom surface of the gate electrode (under the channel region, but now facing up from the inverted substrate). The recessing of the substrate and revealing of the gate electrodes may remove some thickness of the gate meal, but the revealing retains a thickness of the gate electrode between the exposed surface and the channel region (e.g., a nearest of the nanoribbons). The retained thickness is less than or equal to the initial (received or formed) thickness. A well-controlled revealing operation (such as a CMP) may not require so thick a bottom gate metal and may remove a smaller thickness of gate metal from the gate electrode bottom.

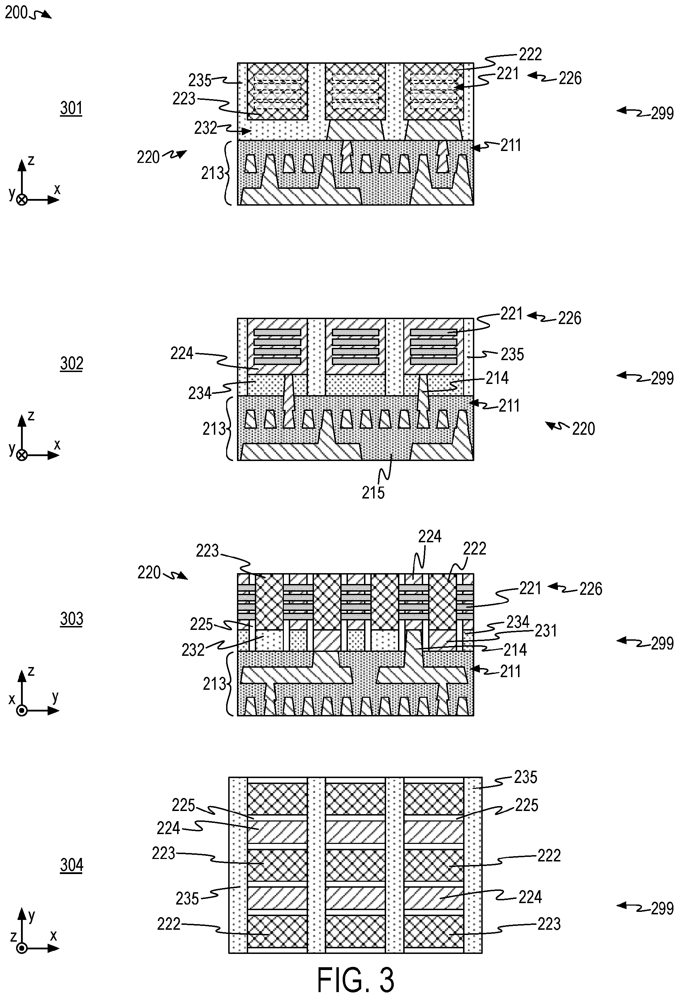

FIG. 3 shows transistor structures 220 having revealed gate electrodes 224 on a back side of substrate 299, in accordance with some embodiments, for example, following a performance of revealing operation 102. Cross-sectional profile views 301, 302, 303 show similar perspectives as views 201, 202, 203 of FIG. 2. Notably, device 200 and substrate 299 are inverted relative to the orientations of FIG. 2. FIG. 3 additionally includes view 304, a plan view of the back side of substrate 299 (now facing up, the positive z-direction).

Besides the inverted orientation, views 301, 302, 303 show similar views of device 200. Notably, the crystalline base material and structures 285, 295 have been removed from the back side of substrate 299. Plan view 304 illustrates the back side of substrate 299 and shows the array of gate electrodes 224 between drain and source regions 222, 223. Gate spacer layers 225 are between gate electrodes 224 and regions 222, 223. Dielectric structure 235 extends in the y-direction between coupled electrodes 224 and regions 222, 223.

Returning to FIG. 1, methods 100 continue at operation 103 by forming alternating first and second rows of first and second sacrificial materials on the substrate. In at least some embodiments, the first rows are formed in contact with the gate electrodes. In many embodiments, forming the alternating first and second rows includes directed self-assembly. In some embodiments, the first rows of the first sacrificial material are formed on the gate electrodes by self-assembled monolayers of a first organic molecule, and the second rows of the second sacrificial material are formed by self-assembled monolayers of a second organic molecule. The second rows are formed between the first rows. For example, two groups of self-assembled monolayers may be deployed, the first with head groups having a strong affinity for gate metal of the gate electrodes and the second with head groups having a strong affinity for the semiconductor material of the drain and source regions.

First and second block co-polymer sacrificial materials may be deployed as tail or functional groups connected to the first and second groups, respectively, of self-assembled monolayers. Example block co-polymers are polystyrene and polymethylmethacrylate, but any suitable sacrificial materials may be utilized. The directed self-assembly may form long-range ordered structures precisely aligned with either the gate electrodes (e.g., the first rows of first sacrificial materials) or the drain and source regions (e.g., the second rows of second sacrificial materials). The ordered structures of sacrificial material bridge the dielectric material(s) separating like structures to form alternating rows of sacrificial material. The self-alignment enabled by the organic monolayers obviates any need for patterning the sacrificial materials and is advantageously much more precise than lithographic patterning. Misalignment of around 5 nm between structures over and under gate electrodes or drain and source regions can be expected just due to typical lithographic patterning. In many embodiments, the sacrificial materials (and subsequent replacement structures) self-assembled on a back side are substantially vertically aligned with front-side structures. Used herein, the term "substantially vertically aligned" denotes an alignment (e.g., of sidewalls) within 5 nm, i.e., having a misalignment of less than 5 nm. More precise alignments can be expected with directed self-assembly of monolayers on the gate electrode array. In some embodiments, the sacrificial materials (and subsequent replacement structures) self-assembled on a back side are precisely vertically aligned with front-side structures. Used herein, the term "precisely vertically aligned" denotes an alignment (e.g., of sidewalls) within 2 nm, i.e., having a misalignment of less than 2 nm. Otherwise, with patterning a back side, misalignments of around 15 or 20 nm can be expected in some dimensions due to wafer distortion (e.g., along certain axes relative to a crystallographic orientation).

The self-alignment enabled by the organic monolayers precisely aligns (e.g., nearly perfectly aligns) the sacrificial materials (and so subsequent replacement structures) with the respective gate electrodes or drain and source regions.

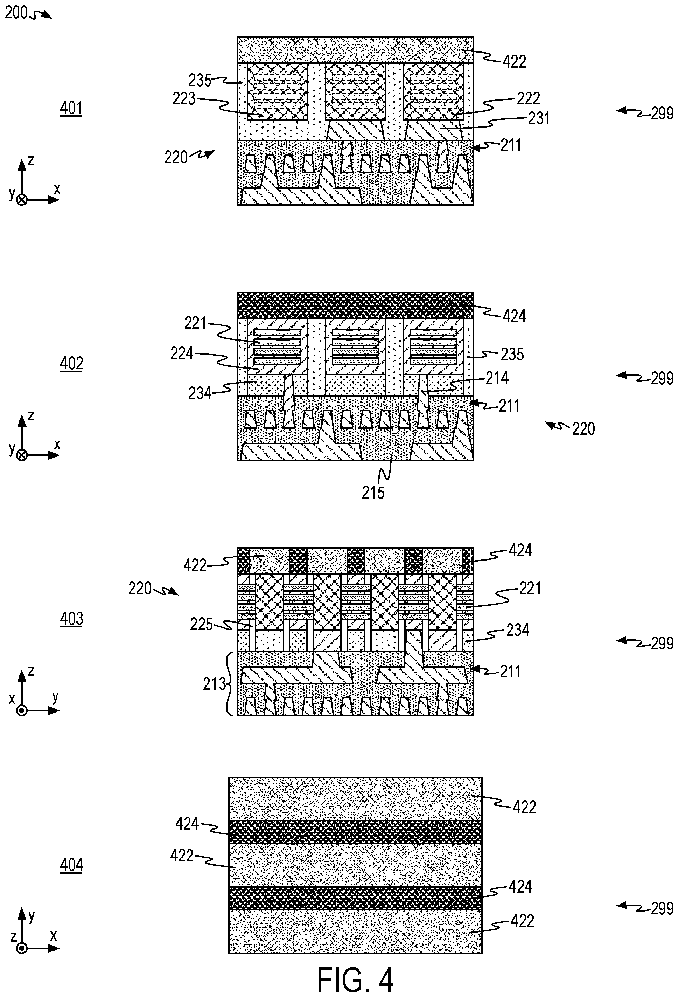

FIG. 4 illustrates transistor structures 220 having alternating first and second rows of first and second sacrificial materials on the back side of substrate 299, in accordance with some embodiments, for example, following a performance of forming operation 103. Parallel and alternating first and second rows of first and second sacrificial materials 424, 422 extend in the x-direction. First sacrificial material 424 extends in the x-direction in rows on gate electrodes 224 in views 402, 403, 404. Second sacrificial material 422 extends in the x-direction in rows on drain and source regions 222, 223 in views 401, 403, 404. As shown in view 403, second sacrificial material 422 is also on gate spacer layers 225 between gate electrodes 224 and regions 222, 223.

Returning to FIG. 1, methods 100 continue by opening gaps between the second rows of second sacrificial material by removing the first rows of first sacrificial material at operation 104. Opening the gaps and removing the first rows may be part of forming gate insulators over the gate electrodes. The gaps are opened over the gate electrodes by removing the first sacrificial material on the gate electrodes. The first sacrificial material may be removed from the gate electrodes, e.g., by selectively stripping off the first block co-polymer from between the second rows of the second sacrificial material.

Methods 100 continue at operation 105 with forming gate insulators by replacing the first sacrificial material with a first dielectric material. The first dielectric material may be any suitable dielectric material and may be deposited by any suitable means. The first dielectric material may include silicon (for example, in an oxide, nitride, carbide, etc., of silicon). The first dielectric material (and so back-side gate insulators) will advantageously have an etch selectivity with subsequent dielectric structures, which may include oxygen. In many embodiments, the first dielectric material of the back-side gate insulators includes silicon and nitrogen. In some embodiments, the first dielectric material is deposited conformally over the gate electrodes and the second sacrificial material. In some such embodiments, the first dielectric material is deposited by an atomic layer deposition (ALD). In some embodiments, the first dielectric material is deposited above a top surface of the second sacrificial material and is subsequently recessed back down. In some such embodiments, a polish (e.g., CMP) or etch is used to recess back the first dielectric material down to the level of, and to expose, the second sacrificial material.

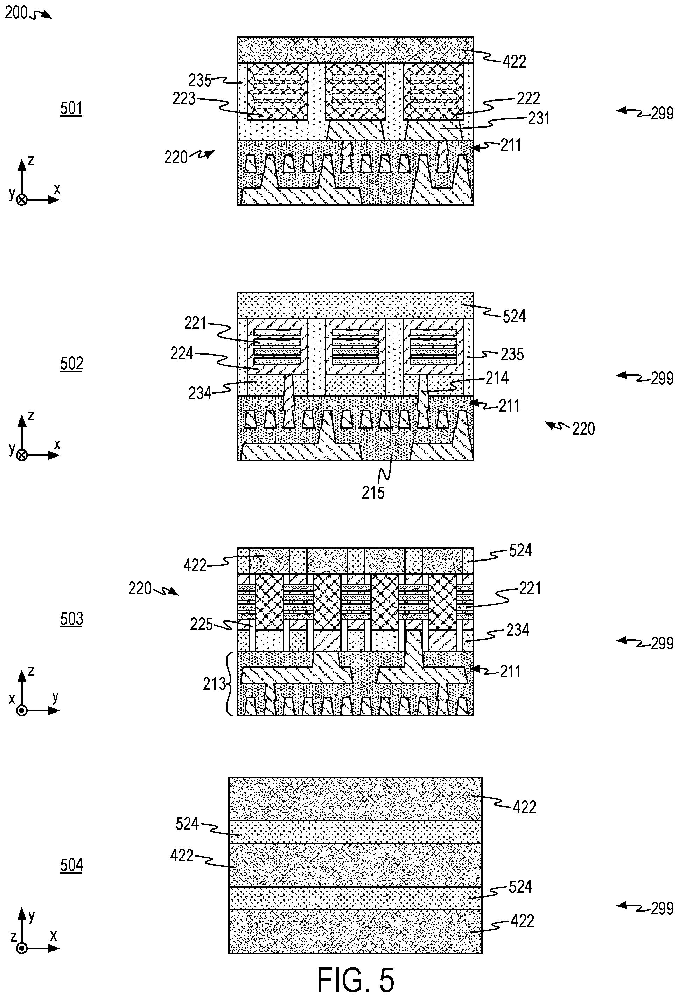

FIG. 5 shows transistor structures 220 having alternating first rows of back-side gate insulators 524 and second rows of second sacrificial material 422 on the back side of substrate 299, in accordance with some embodiments, for example, following performances of opening operation 104 and forming operation 105. Parallel and alternating first rows of back-side gate insulators 524 and second rows of second sacrificial material 422 extend in the x-direction. Back-side gate insulators 524 extend in the x-direction in rows on gate electrodes 224 in views 502, 503, 504. Second sacrificial material 422 extends in the x-direction in rows on drain and source regions 222, 223 in views 501, 503, 504. As shown in view 503, second sacrificial material 422 is also on gate spacer layers 225 between gate electrodes 224 and regions 222, 223. A top surface of insulators 524 and materials 422 has been planarized, as shown in view 503.

Back-side gate insulators 524 are on (e.g., in contact with) gate electrodes 224, as shown in views 502, 503. Insulator 524 is an insulator structure over gate electrode 224 (while substrate 299 is inverted), between gate electrode 224 and the back side of substrate 299. Backside gate insulator 524 is advantageously a low-K dielectric structure or layer, e.g., to minimize capacitances between electrode 224 and adjacent conductors, such as subsequently formed metallization layers. Insulator 524 may include silicon (for example, in an oxide, nitride, carbide, etc., of silicon). Back-side gate insulator 524 advantageously has an etch selectivity with adjacent dielectric structures, such as dielectric structure 235 adjacent and between transistor structures 220 (as shown in views 201, 202). In many embodiments, insulator 524 includes silicon and nitrogen.

Returning to FIG. 1, methods 100 continue with exposing sidewalls of the gate insulators by removing the second rows of second sacrificial materials over the drain and source regions at operation 106. Exposing the sidewalls and removing the second rows of second sacrificial materials may be part of depositing second dielectric layers over the sidewalls of the gate insulators. Gaps are opened between the gate insulators, and sidewalls of the gate insulators are exposed, by removing the second sacrificial material over the drain and source regions. The second sacrificial material may be removed from the drain and source regions, e.g., by stripping off or plasma ashing of the second block co-polymer from between the rows of gate insulators.

Returning to FIG. 1, methods 100 continue at operation 107 by depositing second dielectric layers on and between the gate insulators. The second dielectric layers may be spacer layers and may be substantially conformally deposited, e.g., on sidewalls of (and over) the gate insulators. The second dielectric layers may be formed by physical vapor deposition (PVD), which enables a larger thickness of dielectric to be deposited on upper, horizontal surfaces of the gate insulators, which may in turn allow a subsequent anisotropic etch to expose upper surfaces of drain and source regions. In some embodiments, e.g., because of the perfect alignment of the gate insulators and electrodes, the depositing the second dielectric layers contacts the second dielectric layers to gate spacer layers between the gate electrodes and the drain and source regions.

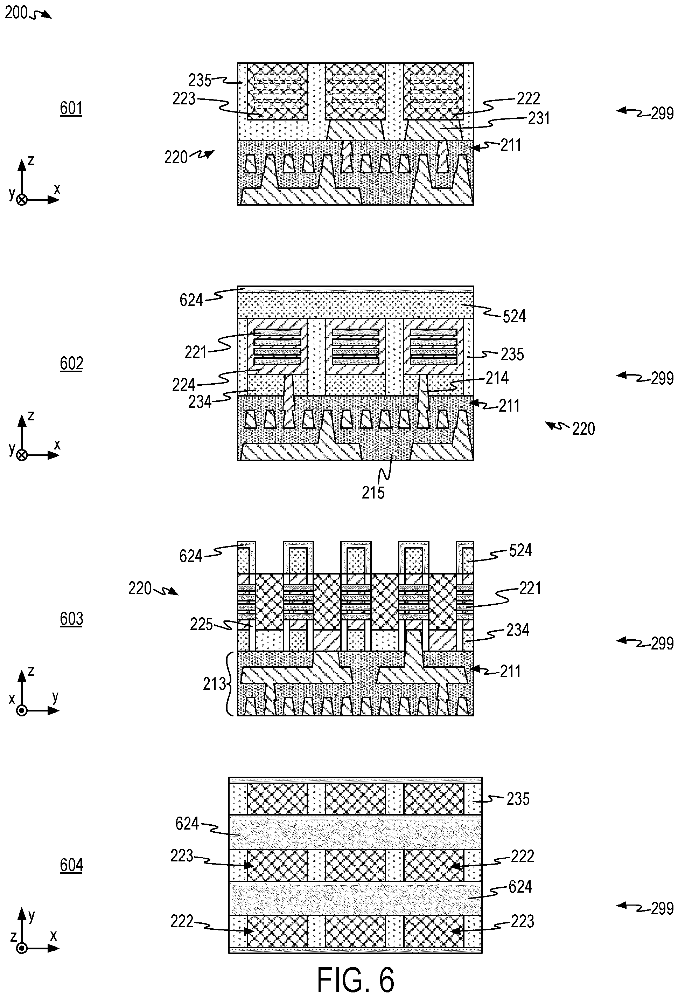

FIG. 6 illustrates transistor structures 220 having spacer layer 624 over gate insulators 524 on the back side of substrate 299, in accordance with some embodiments, for example, following performances of exposing operation 106 and depositing operation 107. Note that view 604 is not strictly of a single x-y viewing plane, e.g., level with a top surface of views 601, 602, 603. In addition to spacer layers 624 on an upper x-y plane, drain and source regions 222, 223 (and dielectric structure 235 therebetween) on a lower x-y plane are shown through openings or gaps between spacer layers 624 over back-side gate insulators 524.

Spacer layer 624 may include silicon (for example, in an oxide, nitride, carbide, etc., of silicon). Spacer layer 624 advantageously has an etch selectivity with adjacent dielectric structures, such as layer 234, dielectric structure 235, etc. In many embodiments, spacer layer 624 includes silicon, oxygen, carbon, and nitrogen.

Returning to FIG. 1, methods 100 continue by forming multiple drain and source insulators by depositing a third dielectric material over the drain and source regions and between the second dielectric layers at operation 108. The third dielectric material may be any suitable (e.g., electrically insulating) material and may be grown or filled between the second dielectric (e.g., spacer) layers by any suitable means. In some embodiments, the third dielectric material is filled or grown onto and over the drain and source regions by the same or similar means as dielectric structure(s) over drain and source regions on the front-side (e.g., between the drain and source regions and the first metallization or interconnect layer(s)). In many embodiments, the third dielectric material include silicon and oxygen and may be grown using any of the conventional means. In some embodiments, the third dielectric material is grown or otherwise deposited to a level over the gate insulators and second dielectric layers. In some such embodiments, the third dielectric material is recessed (e.g., planarized) down at least to a top surface of the second dielectric layers. In some such embodiments, the third dielectric material is recessed (e.g., polished) down at least to a top surface of the gate insulators.

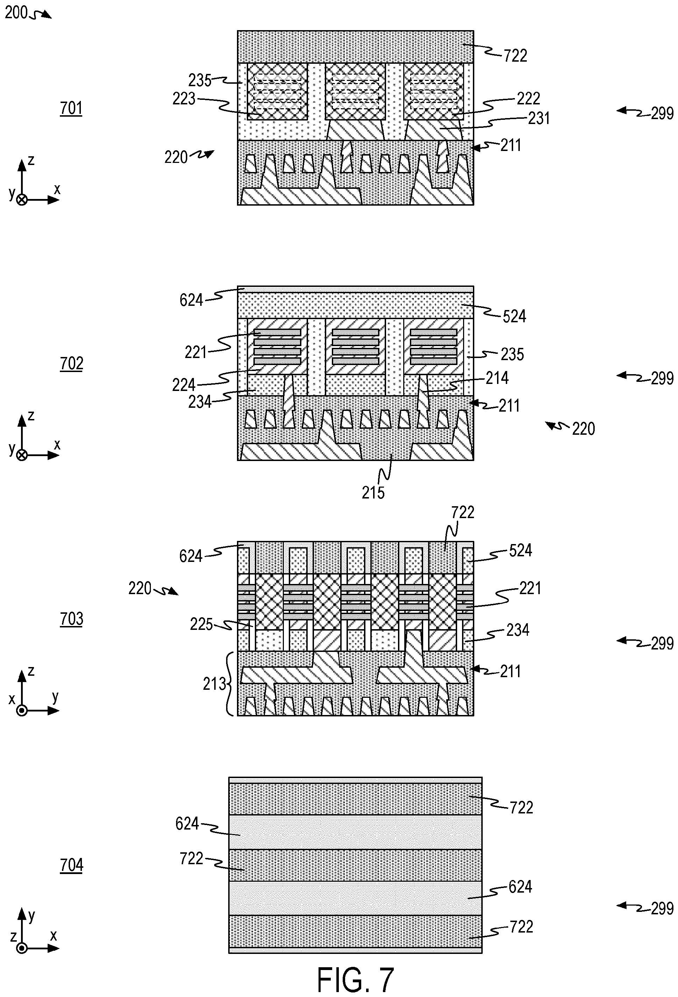

FIG. 7 shows transistor structures 220 having dielectric structures 722 over drain and source regions 222, 223 on the back side of substrate 299, in accordance with some embodiments, for example, following performances of forming operation 108. Spacer layers 624 are over gate insulators 524 on gate electrodes 224, as shown in views 702, 703. Dielectric structures 722 are planarized down to a level with spacer layers 624 over gate insulators 524, as shown in view 703. Dielectric structures 722 and spacer layers 624 form the back-side surface of substrate 299, as shown in views 703, 704.

Back-side drain and source dielectric structures 722 may be similar to front-side dielectric structures 232. As shown in views 701, 703, insulator structures 722 are on drain and source regions 222, 223 and opposite upper metallization layer 211 (which are on a bottom, front-side of inverted substrate 299). Structure 722 is advantageously a low-K dielectric structure or layer, e.g., to minimize capacitances between regions 222, 223 and adjacent conductors, such as subsequently formed metallization layers. Dielectric structure 722 may include silicon (for example, in an oxide, nitride, carbide, etc., of silicon). Dielectric structure 722 advantageously has an etch selectivity with adjacent dielectric structures, such as layers 225, 624 and insulators 524. In some embodiments, insulator structures 722 have a same composition as dielectric structure 232.

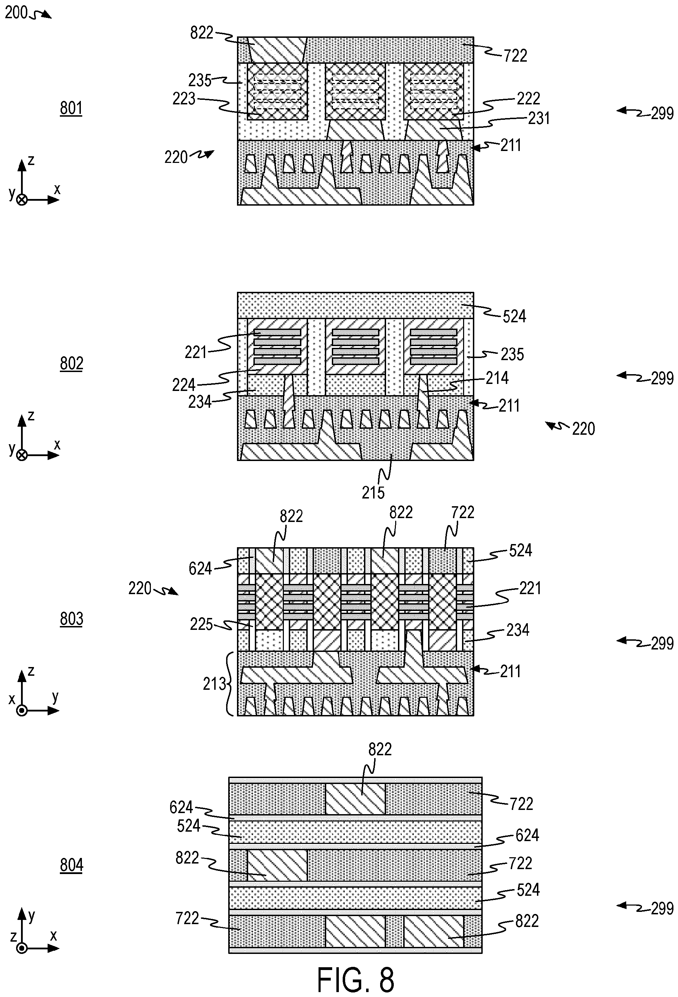

Returning to FIG. 1, methods 100 continue at operation 109 with forming contacts (e.g., on the back side, opposite the interconnect or metallization layer) to at least some of the gate electrodes and the drain and source regions. The contacts may be formed through the back-side gate or drain and source insulators. Some of the gate electrodes and the drain and source regions may be contacted on the front side, and so may not be contacted on the back side. Forming the contacts may use lithographic patterning, but the contacts may be effectively self-aligned with the respective electrodes or regions to be coupled by using etch selectivities between the gate insulators and the drain and source insulators. In at least embodiments utilizing directed self-assembly of monolayers at operation 103, the gate insulators and the drain and source insulators were precisely (e.g., nearly perfectly) aligned (by the corresponding sacrificial materials) to respective gate electrodes or drain and source regions. The contacts may then be formed through the respective gate or drain and source insulators using an etch selective to the desired back-side insulator. Any patterning and etching would have advantageously large margins for placement errors (etc.) either due to relatively large structural dimensions in the x-directions (for example, in FIG. 8, e.g., of gate electrodes or drain and source regions) or, moving in the y-directions, due to the etch selectivities between rows of materials.

The back-side contacts to at least some of the gate electrodes and the drain and source regions may be formed by any suitable means, for example, by anisotropic dry etching and subsequent deposition of a conductive material, such as a metal. The dry etch may be by, e.g., a reactive ion etch (RIE), such as a deep RIE (DRIE). The deposition may be by, e.g., a PVD or chemical vapor deposition (CVD). In at least some embodiments, a second interconnect or metallization network is formed on the back side, and the back-side interconnect or metallization network is coupled to the back-side contacts and to the first metallization network on the front side. Back-side interconnect or metallization layers may be formed by patterning, etching, and metallizing similar to that used for forming back-side contacts or front-side interconnect or metallization layers. Subsequent layers of dielectric materials may be built up iteratively, one over another, after a previous, lower interconnect layer is patterned and metallized. Back-side contacts and interconnect or metallization layers may include the same or other materials (e.g., metals and dielectrics) described for front-side interconnect or metallization layers, for example, at FIGS. 1 (e.g., at operation 101) and 2 (e.g., about dielectric materials 215 and other dielectric materials).

FIG. 8 illustrates transistor structures 220 having metal contacts 822 over drain and source regions 222, 223 on the back side of substrate 299, in accordance with some embodiments, for example, following a performance of forming operation 109. Back-side drain and source contacts 822 connect to drain and source regions 222, 223 through back-side drain and source dielectric structures 722. View 801 shows back-side contact 822 contacting source region 223 through dielectric structure 722. View 802 shows gate electrodes 224 uncontacted on the back side of substrate 299. View 803 shows back-side contacts 822 contacting drain and source regions 222, 223, and views 803, 804 show back-side contacts 822 between spacer layers 624.

FIG. 8 (e.g., views 801, 804) illustrates how back-side contacts 822 are effectively self-aligned. Using a contact etch selective to the material of dielectric structures 722 provides significant margin for placement error in the y-dimension. The long dimension of drain and source regions 222, 223 (as well as the wide gap of dielectric structure 235 between adjacent drain and source regions 222, 223) provides significant margin for placement error in the x-dimension.

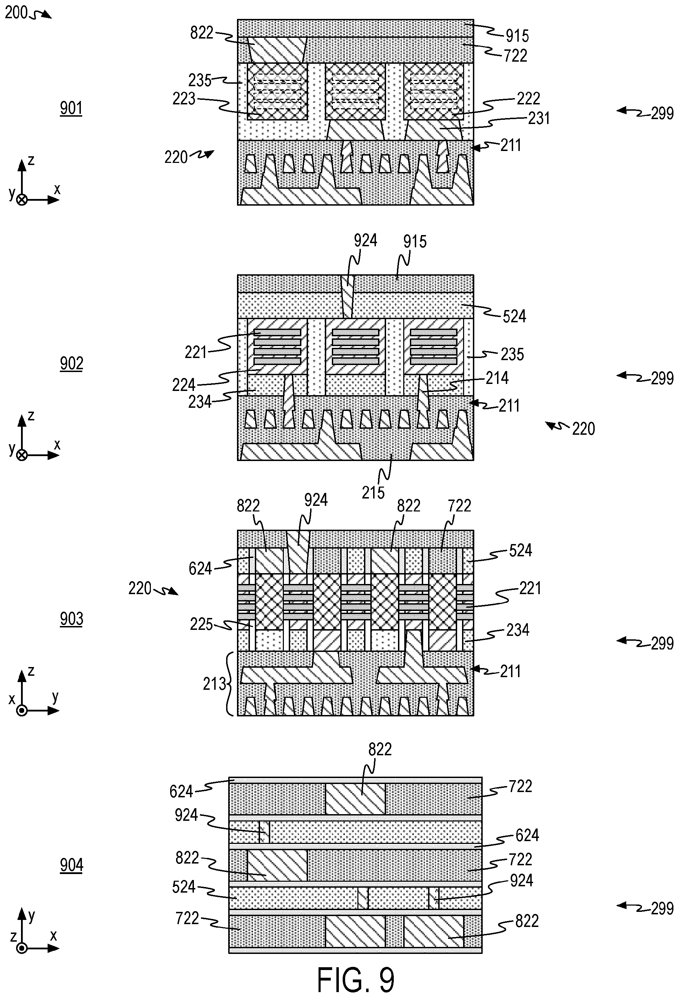

FIG. 9 shows transistor structures 220 having metal vias or contacts 924 over gate electrodes 224 on the back side of substrate 299, in accordance with some embodiments, for example, following a performance of forming operation 109. Back-side gate contacts 924 connect to gate electrodes 224 through back-side gate insulators 524 and a dielectric layer 915. Back-side gate contacts 924 connecting to gate electrodes 224 through back-side gate insulators 524 may or may not be shown in view 903, e.g., depending on the position of contacts 924 in the x-dimension relative the plane of view 903. Rather than the back-side surface of substrate 299 (which would be a nearly blank field of layer 915 with limited interruptions of contacts 924), view 904 shows an x-y plane at a top of contacts 822, e.g., for illustrative purposes.

In some embodiments, additional dielectric layer 915 is deployed over insulators 524, dielectric structures 722, contacts 822, etc., as shown in views 901, 902, 903. In some such embodiments, layer 915 is an inter-layer dielectric (ILD) layer 915 deployed to provide, for example, additional electrical isolation, improved reliability, etch selectivity, etc. ILD layer 915 may have the same or different composition as other dielectric structures in device 200, such as material 215, structure 235, insulators 524, structures 722, etc. Layer 915 may include silicon (for example, in an oxide, nitride, carbide, etc., of silicon). In many embodiments, ILD layer 915 includes silicon and oxygen.

FIG. 9 (e.g., views 902, 904) illustrates how back-side contacts 924 are effectively self-aligned. Using a contact etch selective to the material of gate insulators 524 provides significant margin for placement error in the y-dimension. The long dimension of gate electrodes 224 (as well as the wide gap of dielectric structure 235 between adjacent gate electrodes 224) provides significant margin for placement error in the x-dimension.

Returning to FIG. 1, methods 100 continue at operation 110 by outputting IC device 200. Outputting device 200 may include sending device 200 on to subsequent operations on substrate 299 (such as dicing, bonding, packaging, etc.). Other operations may be employed.

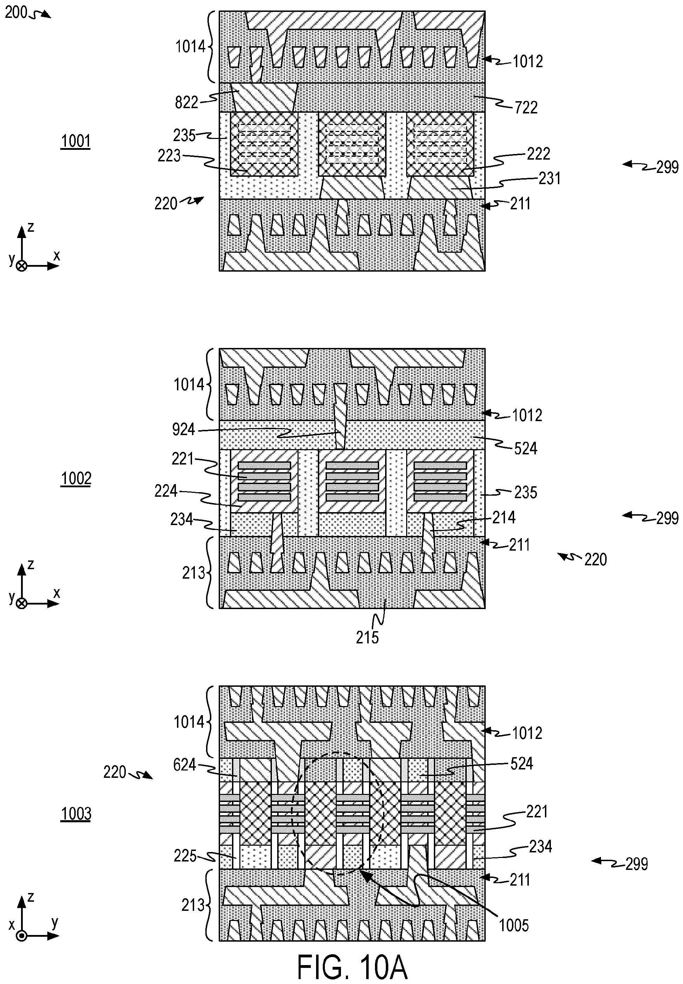

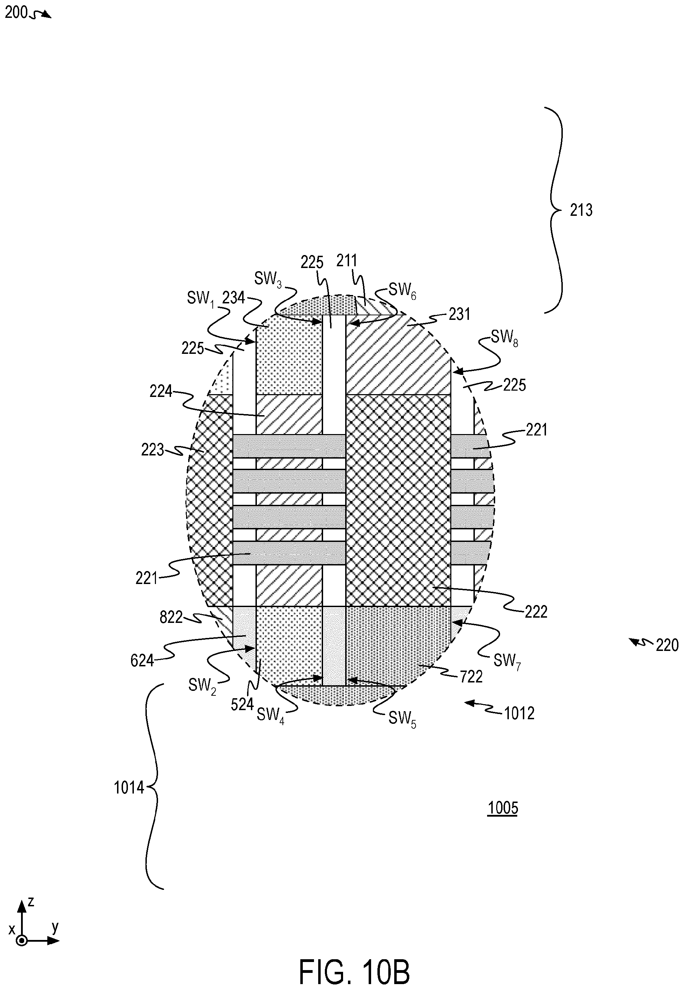

FIGS. 10A and 10B illustrate cross-sectional profile views of IC device 200 having transistor structures 220 between and coupled to front- and back-side layers 211, 1012 in frontand back-side interconnect networks 213, 1014, in accordance with some embodiments, for example, following performances of operations 109, 110. Notably, substrate 299 is still inverted, and the back-side of substrate 299 (including back-side layers 1012 in back-side interconnect network 1014) is still up, as shown in views 1001, 1002, 1003. FIG. 10A shows some of drain and source regions 222, 223 are coupled to front-side layers 211 and network 213 (e.g., through contacts 231), and some of drain and source regions 222, 223 are coupled to back-side layers 1012 and network 1014 (e.g., through contacts 822). Some of gate electrodes 224 are coupled to front-side layers 211 and network 213 (e.g., through contacts or vias 214), and some of gate electrodes 224 are coupled to back-side layers 1012 and network 1014 (e.g., through contacts 924). In expanded view 1005 of FIG. 10B, substrate 299 is inverted from the perspective shown by a dashed circle in FIG. 10A to show front-side up and back-side down.

Device 200 includes front- and back-side metallization layers 211, 1012 and transistor structure 220. Transistor structure 220 includes a stack of nanoribbons 221 between and coupling drain and source regions 222, 223, and gate electrode 224 adjacent nanoribbons 221. Front-side metallization layer 211 is over and coupled to drain region 222. Source region 223 is over and coupled to back-side metallization layer 1012. Note that, although not separately labeled, the ILD of FIG. 9 may be present and included within, e.g., back-side interconnect layer 1012 and network 1014.

In some embodiments, gate electrodes have a first vertical pitch P₁ greater a second vertical pitch P₂, and a first metal thickness T₁ greater than thickness T₂, much as described at FIGS. 1 and 2.

FIG. 10B illustrates precisely aligned sidewalls of various layers and structures in expanded view 1005 of device 200. Substrate 299 is inverted in view 1005 from the perspective of view 1003 at FIG. 10A. Front-side interconnect network 213 is over transistor structure 220, and transistor structure 220 is over back-side interconnect network 1014.

Device 200 includes front-side gate layer 234 on gate electrode 224 and between front-side metallization layer 211 (and network 213) and gate electrode 224. Device 200 includes back-side gate insulators 524 on gate electrode 224 and between gate electrode 224 and the backside metallization layer (and network 1014, over and coupled to back-side contact 822 on source region 223). In some embodiments, a first sidewall SW₁ of front-side gate layer 234 is substantially vertically aligned over a second sidewall SW₂ of back-side gate insulators 524, and a third sidewall SW₃ of the gate layer 234 is substantially vertically aligned over a fourth sidewall SW₄ of back-side gate insulators 524. In some such embodiments, first sidewall SW₁ is precisely vertically aligned over second sidewall SW₂, and third sidewall SW₃ is precisely vertically aligned over fourth sidewall SW₄.

Back-side drain dielectric structure 722 is on drain region 222 and between the backside metallization layer 1012 (and network 1014) and drain region 222. Gate spacer layer 225 is between gate electrode 224 and drain region 222 and in contact with gate electrode 224, gate layer 234, and drain region 222. Back-side spacer layer 624 is in contact with back-side gate insulator 524, back-side drain dielectric structure 722, and front-side gate spacer layer 225. In some embodiments, front- and back-side spacer layers 225, 624 have a same composition as formed. However, due to exposure to extra processing received by the first-formed layers 225, a chemical or physical interface may be observed where layers 225, 624 adjoin. Such an interface may show, e.g., a stoichiometric difference between the layers. Other interfaces may be observed.

In some embodiments, a fifth sidewall SW₅ of back-side drain dielectric structure 722 is substantially vertically aligned with a sixth sidewall SW₆ of front-side gate spacer layer 225 between drain region 222 and front-side metallization layer 211, and a seventh sidewall SW₇ of back-side drain dielectric structure 722 is substantially vertically aligned over an eighth sidewall SW₈ of a second front-side gate spacer layer 225 where drain region 222 is on and between the first and second front-side gate spacer layer 225. In some such embodiments, fifth sidewall SW₅ is precisely vertically aligned over sixth sidewall SW₆, and seventh sidewall SW₇ is precisely vertically aligned over eighth sidewall SW₈.

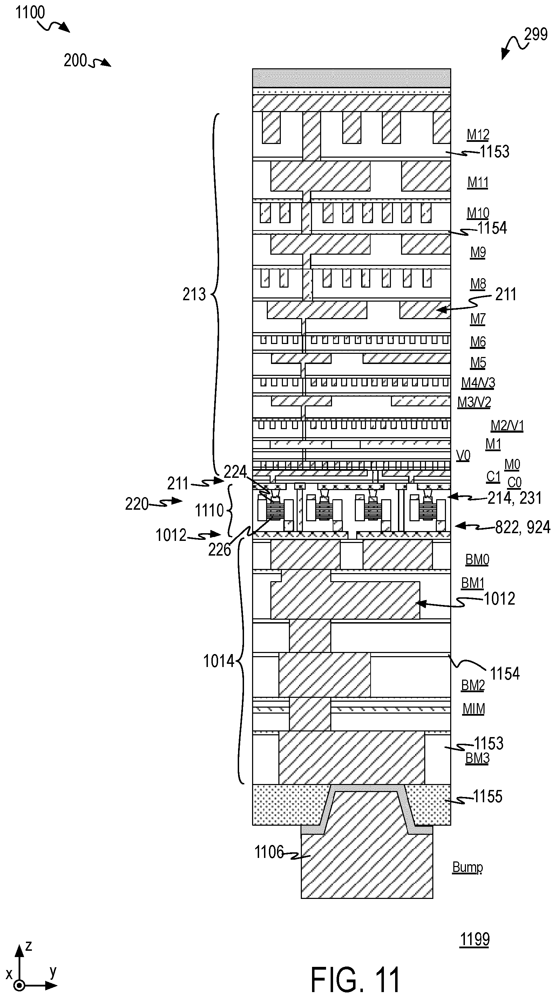

FIG. 11 illustrates a cross-sectional profile view of IC system 1100 having transistor structures 220 with front- and back-side contacts 231, 822, 924 and vias 214 to front- and backside interconnect layers 211, 1012, in accordance with some embodiments. In the example of IC system 1100, IC die or other substrate 299 includes transistor structures 220 having interconnections between front-side layers 211 in front-side interconnect network 213 and backside layers 1012 in back-side interconnect network 1014. IC system 1100 includes a lateral surface along the x-y plane that may be defined or taken at any vertical position of IC system 1100. The lateral surface of the x-y plane is orthogonal to a vertical or build-up dimension as defined by the z-axis. In some embodiments, IC system 1100 may be formed from any substrate material suitable for the fabrication of transistor circuitry. In some embodiments, a semiconductor substrate is used to manufacture transistor structures 220 and other transistors and components of IC system 1100. The semiconductor substrate 299 may include a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as gallium arsenide. The substrate may also include semiconductor materials, metals, dielectrics, dopants, and other materials commonly found in semiconductor substrates.

In FIG. 11, IC system 1100 includes an IC die or substrate 299, which is a monolithic IC as described above, including transistor structures 220 and various contacts and vias through insulating layers and other structures, front-side metallization layers 211 (or front-side interconnect layers), and back-side metallization layers 1012 (or back-side interconnect layers). As shown, transistor structures 220 are embedded within a dielectric layer 1110. As shown, each transistor structure 220 includes channel regions 226 (e.g., within fins, nanoribbons, etc.) and gate electrodes 224. Each of transistor structures 220 also include source and drain regions and source and drain contacts. In some embodiments, front-side metallization layers 211 provide signal routing to transistor structures 220 and back-side metallization layers 1012 provide power delivery, as enabled by back-side contacts 822, etc., to transistor structures 220.

Interconnectivity of transistor structures 220 (and other transistors, etc.), signal routing to and from memory arrays, etc., power delivery, etc., and routing to an outside device (not shown), is provided by front-side metallization layers 211 and network 213, back-side metallization layers 1012 and network 1014, and package-level interconnects 1106. In the example of FIG. 11, package-level interconnects 1106 are provided on or over a back-side of IC die or substrate 299 as bumps over a passivation layer 1155, and IC system 1100 is attached to a substrate 1199 (such as a package substrate 1199) and coupled to signal routing, power delivery, etc., by package-level interconnects 1106. Front- and back-side interconnect networks 213, 1014 (including metallization layers 211, 1012) are coupled to substrate 1199. In some embodiments, interconnect networks 213, 1014 (including metallization layers 211, 1012) are coupled to a power supply through substrate 1199. However, package-level interconnects 1106 may be provided using any suitable interconnect structures such as bond pads, solder bumps, etc. Furthermore, in some embodiments, package-level interconnects 1106 are provided on or over a front-side of IC die or substrate 299 (i.e., over front-side metallization layers 211).

In the illustrated example, front-side metallization layers 211 include M0, V0, M1, M2/V1, M3/V2, M4/V3, and M4-M12. However, front-side metallization layers 211 may include any number of metallization layers such as eight or more metallization layers. Similarly, back-side metallization layers 1012 include BM0, BM1, BM2, and BM3. However, back-side metallization layers 1012 may include any number of metallization layers such as two to five metallization layers. Front-side metallization layers 211 and back-side metallization layers 1012 are embedded within dielectric materials 1153, 1154. Furthermore, optional metal-insulator-metal (MIM) devices such as diode devices may be provided within back-side metallization layers 1012. Other devices such as capacitive memory devices may be provided within front-side metallization layers 211 and/or back-side metallization layers 1012.

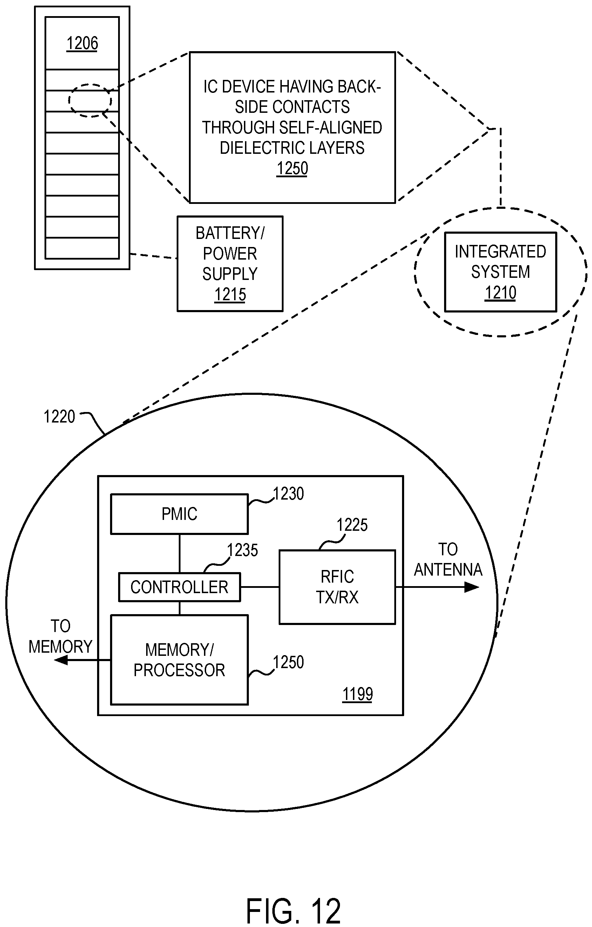

FIG. 12 illustrates a diagram of an example data server machine 1206 employing an IC device having back-side contacts through self-aligned dielectric layers, in accordance with some embodiments, e.g., formed by replacing self-assembled monolayer sacrificial materials. Server machine 1206 may be any commercial server, for example, including any number of highperformance computing platforms disposed within a rack and networked together for electronic data processing, which in the exemplary embodiment includes one or more devices 1250 having back-side contacts through self-aligned dielectric layers.

Also as shown, server machine 1206 includes a battery and/or power supply 1215 to provide power to devices 1250, and to provide, in some embodiments, power delivery functions such as power regulation. Devices 1250 may be deployed as part of a package-level integrated system 1210. Integrated system 1210 is further illustrated in the expanded view 1220. In the exemplary embodiment, devices 1250 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 1250 is a microprocessor including a static RAM (SRAM) cache memory. As shown, device 1250 may be an IC device having backside contacts through self-aligned dielectric layers, as discussed herein. Device 1250 may be further coupled to (e.g., communicatively coupled to) a board, an interposer, or a substrate 1199 along with, one or more of a power management IC (PMIC) 1230, RF (wireless) IC (RFIC) 1225 including a wideband RF (wireless) transmitter and/or receiver (TX/RX) (e.g., including a digital baseband and an analog front end module further includes a power amplifier on a transmit path and a low noise amplifier on a receive path), and a controller 1235 thereof. In some embodiments, RFIC 1225, PMIC 1230, controller 1235, and device 1250 include having backside contacts through self-aligned dielectric layers.

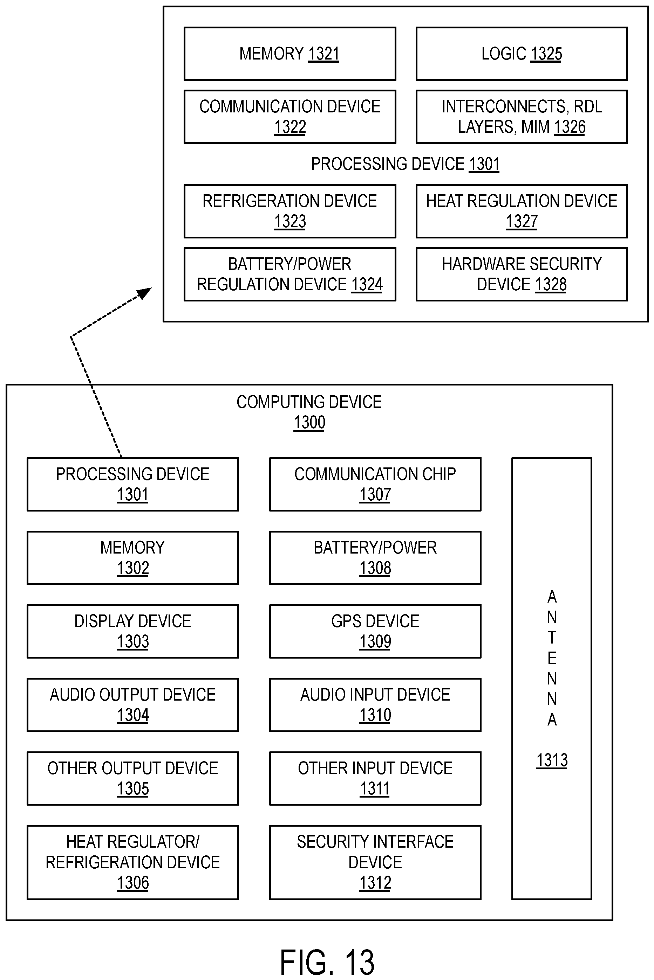

FIG. 13 is a block diagram of an example computing device 1300, in accordance with some embodiments. For example, one or more components of computing device 1300 may include any of the devices or structures discussed herein. A number of components are illustrated in FIG. 13 as being included in computing device 1300, but any one or more of these components may be omitted or duplicated, as suitable for the application. In some embodiments, some or all of the components included in computing device 1300 may be attached to one or more printed circuit boards (e.g., a motherboard). In some embodiments, various ones of these components may be fabricated onto a single system-on-a-chip (SoC) die. Additionally, in various embodiments, computing device 1300 may not include one or more of the components illustrated in FIG. 13, but computing device 1300 may include interface circuitry for coupling to the one or more components. For example, computing device 1300 may not include a display device 1303, but may include display device interface circuitry (e.g., a connector and driver circuitry) to which display device 1303 may be coupled. In another set of examples, computing device 1300 may not include an audio output device 1304, other output device 1305, global positioning system (GPS) device 1309, audio input device 1310, or other input device 1311, but may include audio output device interface circuitry, other output device interface circuitry, GPS device interface circuitry, audio input device interface circuitry, audio input device interface circuitry, to which audio output device 1304, other output device 1305, GPS device 1309, audio input device 1310, or other input device 1311 may be coupled.

Computing device 1300 may include a processing device 1301 (e.g., one or more processing devices). As used herein, the term "processing device" or "processor" indicates a device that processes electronic data from registers and/or memory to transform that electronic data into other electronic data that may be stored in registers and/or memory. Processing device 1301 may include a memory 1321, a communication device 1322, a refrigeration device 1323, a battery/power regulation device 1324, logic 1325, interconnects 1326 (i.e., optionally including redistribution layers (RDL) or metal-insulator-metal (MIM) devices), a heat regulation device 1327, and a hardware security device 1328.

Processing device 1301 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 1300 may include a memory 1302, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1302 includes memory that shares a die with processing device 1301. This memory may be used as cache memory and may include embedded dynamic random-access memory (eDRAM) or spin transfer torque magnetic random-access memory (STT-MRAM).

Computing device 1300 may include a heat regulation/refrigeration device 1306. Heat regulation/refrigeration device 1306 may maintain processing device 1301 (and/or other components of computing device 1300) at a predetermined low temperature during operation.

In some embodiments, computing device 1300 may include a communication chip 1307 (e.g., one or more communication chips). For example, the communication chip 1307 may be configured for managing wireless communications for the transfer of data to and from computing device 1300. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 1307 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1307 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1307 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1307 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1307 may operate in accordance with other wireless protocols in other embodiments. Computing device 1300 may include an antenna 1313 to facilitate wireless communications and/or to receive other wireless communications (such as AM or FM radio transmissions).

In some embodiments, communication chip 1307 may manage wired communications, such as electrical, optical, or any other suitable communication protocols (e.g., the Ethernet). As noted above, communication chip 1307 may include multiple communication chips. For instance, a first communication chip 1307 may be dedicated to shorter-range wireless communications such as Wi-Fi or Bluetooth, and a second communication chip 1307 may be dedicated to longer-range wireless communications such as GPS, EDGE, GPRS, CDMA, WiMAX, LTE, EV-DO, or others. In some embodiments, a first communication chip 1307 may be dedicated to wireless communications, and a second communication chip 1307 may be dedicated to wired communications.

Computing device 1300 may include battery/power circuitry 1308. Battery/power circuitry 1308 may include one or more energy storage devices (e.g., batteries or capacitors) and/or circuitry for coupling components of computing device 1300 to an energy source separate from computing device 1300 (e.g., AC line power).

Computing device 1300 may include a display device 1303 (or corresponding interface circuitry, as discussed above). Display device 1303 may include any visual indicators, such as a heads-up display, a computer monitor, a projector, a touchscreen display, a liquid crystal display (LCD), a light-emitting diode display, or a flat panel display, for example.

Computing device 1300 may include an audio output device 1304 (or corresponding interface circuitry, as discussed above). Audio output device 1304 may include any device that generates an audible indicator, such as speakers, headsets, or earbuds, for example.

Computing device 1300 may include an audio input device 1310 (or corresponding interface circuitry, as discussed above). Audio input device 1310 may include any device that generates a signal representative of a sound, such as microphones, microphone arrays, or digital instruments (e.g., instruments having a musical instrument digital interface (MIDI) output).

Computing device 1300 may include a GPS device 1309 (or corresponding interface circuitry, as discussed above). GPS device 1309 may be in communication with a satellite-based system and may receive a location of computing device 1300, as known in the art.

Computing device 1300 may include other output device 1305 (or corresponding interface circuitry, as discussed above). Examples of the other output device 1305 may include an audio codec, a video codec, a printer, a wired or wireless transmitter for providing information to other devices, or an additional storage device.

Computing device 1300 may include other input device 1311 (or corresponding interface circuitry, as discussed above). Examples of the other input device 1311 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1300 may include a security interface device 1312. Security interface device 1312 may include any device that provides security measures for computing device 1300 such as intrusion detection, biometric validation, security encode or decode, access list management, malware detection, or spyware detection.

Computing device 1300, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1-13. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes first and second metallization layers, and a transistor structure including a stack of nanoribbons between and coupling first and second impurity doped regions, and a gate electrode adjacent the nanoribbons, wherein the first metallization layer is over and coupled to the first impurity doped region, the second impurity doped region is over and coupled to the second metallization layer, and a first vertical pitch between a lowest of the nanoribbons and a lowest surface of the gate electrode is greater than one-and-a-half times a second vertical pitch between the lowest of the nanoribbons and a next lowest of the nanoribbons.

In one or more second embodiments, further to the first embodiments, the first vertical pitch is greater than twice the second vertical pitch.

In one or more third embodiments, further to the first or second embodiments, the first vertical pitch is greater than 20 nm.

In one or more fourth embodiments, further to the first through third embodiments, the apparatus also includes a first dielectric structure on the gate electrode and between the first metallization layer and the gate electrode, and a second dielectric structure on the gate electrode and between the gate electrode and the second metallization layer, wherein a first sidewall of the first dielectric structure is substantially vertically aligned over a second sidewall of the second dielectric structure, and a third sidewall of the first dielectric structure is substantially vertically aligned over a fourth sidewall of the second dielectric structure.

In one or more fifth embodiments, further to the first through fourth embodiments, the first sidewall is precisely vertically aligned over the second sidewall, and the third sidewall is precisely vertically aligned over the fourth sidewall.

In one or more sixth embodiments, further to the first through fifth embodiments, the apparatus also includes a third dielectric structure on the first impurity doped region and between the second metallization layer and the first impurity doped region, a first insulator layer between the gate electrode and the first impurity doped region and in contact with the gate electrode, the first dielectric structure, and the first impurity doped region, and a second insulator layer in contact with the second and third dielectric structures and the first insulator layer.

In one or more seventh embodiments, further to the first through sixth embodiments, a fifth sidewall of the third dielectric structure is substantially vertically aligned with a sixth sidewall of the first insulator layer between the first impurity doped region and the first metallization layer, and a seventh sidewall of the third dielectric structure is substantially vertically aligned over an eighth sidewall of a third insulator layer, the first impurity doped region on and between the first and third insulator layers.

In one or more eighth embodiments, further to the first through seventh embodiments, the fifth sidewall is precisely vertically aligned over the sixth sidewall, and the seventh sidewall is precisely vertically aligned over the eighth sidewall.

In one or more ninth embodiments, further to the first through eighth embodiments, the second metallization layer is coupled to a substrate and a power supply through the substrate.

In one or more tenth embodiments, an apparatus includes first and second metallization layers, and a transistor structure including a gate electrode between source and drain regions and between and in contact with first and second dielectric structures, the transistor structure between and coupled to the first and second metallization layers, wherein the first and second dielectric structures are between the first and second metallization layers, a third dielectric structure is between the second metallization layer and a first of the source and drain regions, a first insulator layer is between the gate electrode and the first of the source and drain regions and in contact with the gate electrode, the first dielectric structure, and the first of the source and drain regions, and a second insulator layer is in contact with the second and third dielectric structures and the first insulator layer.

In one or more eleventh embodiments, further to the tenth embodiments, the transistor structure includes a stack of nanoribbons between and coupling the source and drain regions, and a first vertical pitch between a lowest of the nanoribbons and a lowest surface of the gate electrode is greater than one-and-a-half times a second vertical pitch between the lowest of the nanoribbons and a next lowest of the nanoribbons.

In one or more twelfth embodiments, further to the tenth or eleventh embodiments, the first vertical pitch is greater than 20 nm.

In one or more thirteenth embodiments, further to the tenth through twelfth embodiments, a first sidewall of the first dielectric structure is substantially vertically aligned over a second sidewall of the second dielectric structure, and a third sidewall of the first dielectric structure is substantially vertically aligned over a fourth sidewall of the second dielectric structure.

In one or more fourteenth embodiments, further to the tenth through thirteenth embodiments, the first sidewall is precisely vertically aligned over the second sidewall, and the third sidewall is precisely vertically aligned over the fourth sidewall.

In one or more fifteenth embodiments, a method includes forming alternating first and second rows of first and second sacrificial materials on a first side of a substrate, wherein the substrate includes a plurality of transistor structures coupled to a metallization network on a second side opposite the first side, the plurality of transistor structures includes a plurality of gate electrodes between a plurality of source and drain regions, and the first rows are in contact with the plurality of gate electrodes, forming a plurality of gate insulators by replacing the first sacrificial material with a first dielectric material, depositing second dielectric layers on and between the gate insulators, forming a plurality of source and drain insulators by depositing a third dielectric material over the source and drain regions and between the second dielectric layers, and forming a plurality of contacts on the first side to at least some of the gate electrodes and the source and drain regions and through the gate insulators and the source and drain insulators.

In one or more sixteenth embodiments, further to the fifteenth embodiments, the method also includes forming the gate electrodes, wherein a first of the transistor structures includes a stack of nanoribbons extending through a first of the gate electrodes, and the forming the gate electrodes includes depositing a metal to a first thickness between a surface of the first of the gate electrodes and a nearest of the nanoribbons to the surface and to a second thickness between the nearest of the nanoribbons and a next nearest of the nanoribbons to the surface, the surface of the first of the gate electrodes is opposite the metallization network and the second side, and the first thickness is greater than one-and-a-half times the second thickness.

In one or more seventeenth embodiments, further to the fifteenth or sixteenth embodiments, the method also includes revealing the gate electrodes on the first side of the substrate, wherein the revealing the gate electrodes exposes the surface and retains a third thickness of the gate electrode between the surface and the nearest of the nanoribbons, and the third thickness is less than or equal to the first thickness.

In one or more eighteenth embodiments, further to the fifteenth through seventeenth embodiments, the first sacrificial material of the first rows and the second sacrificial material of the second rows include self-assembled monolayers of organic molecules, and the forming the alternating first and second rows includes directed self-assembly.

In one or more nineteenth embodiments, further to the fifteenth through eighteenth embodiments, the depositing the second dielectric layers contacts the second dielectric layers to fourth dielectric layers between the gate electrodes and the source and drain regions.

In one or more twentieth embodiments, further to the fifteenth through nineteenth embodiments, the metallization network on the second side of the substrate is a first metallization network, also including forming a second metallization network on the first side, the second metallization network coupled to the plurality of contacts on the first side and to the first metallization network on the second side.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
first and second metallization layers; and
a transistor structure comprising a stack of nanoribbons between first and second impurity doped regions, and a gate electrode adjacent the nanoribbons, wherein:
the first metallization layer is over the first impurity doped region;
the second impurity doped region is over the second metallization layer; and
a first vertical pitch between a lowest of the nanoribbons and a lowest surface of the gate electrode is greater than one-and-a-half times a second vertical pitch between the lowest of the nanoribbons and a next lowest of the nanoribbons.

2. The apparatus of claim 1, wherein the first vertical pitch is greater than twice the second vertical pitch.

3. The apparatus of either claim 1 or 2, wherein the first vertical pitch is greater than 20 nm.

4. The apparatus of any one of claims 1-3, further comprising a first dielectric structure on the gate electrode and between the first metallization layer and the gate electrode, and a second dielectric structure on the gate electrode and between the gate electrode and the second metallization layer, wherein a first sidewall of the first dielectric structure is substantially vertically aligned over a second sidewall of the second dielectric structure, and a third sidewall of the first dielectric structure is substantially vertically aligned over a fourth sidewall of the second dielectric structure.

5. The apparatus of claim 4, wherein the first sidewall is precisely vertically aligned over the second sidewall, and the third sidewall is precisely vertically aligned over the fourth sidewall.

6. The apparatus of either claim 4 or 5, further comprising:
a third dielectric structure on the first impurity doped region and between the second metallization layer and the first impurity doped region;
a first insulator layer between the gate electrode and the first impurity doped region and in contact with the gate electrode, the first dielectric structure, and the first impurity doped region; and
a second insulator layer in contact with the second and third dielectric structures and the first insulator layer.

7. The apparatus of claim 6, wherein a fifth sidewall of the third dielectric structure is substantially vertically aligned with a sixth sidewall of the first insulator layer between the first impurity doped region and the first metallization layer, and a seventh sidewall of the third dielectric structure is substantially vertically aligned over an eighth sidewall of a third insulator layer, the first impurity doped region on and between the first and third insulator layers.

8. The apparatus of claim 7, wherein the fifth sidewall is precisely vertically aligned over the sixth sidewall, and the seventh sidewall is precisely vertically aligned over the eighth sidewall.

9. The apparatus of any one of claims 1-8, wherein the second metallization layer is coupled to a substrate and a power supply through the substrate.

10. A method, comprising:
forming alternating first and second rows of first and second sacrificial materials on a first side of a substrate, wherein the substrate comprises a plurality of transistor structures coupled to a metallization network on a second side opposite the first side, the plurality of transistor structures comprises a plurality of gate electrodes between a plurality of source and drain regions, and the first rows are in contact with the plurality of gate electrodes;
forming a plurality of gate insulators by replacing the first sacrificial material with a first dielectric material;
depositing second dielectric layers on and between the gate insulators;
forming a plurality of source and drain insulators by depositing a third dielectric material over the source and drain regions and between the second dielectric layers; and
forming a plurality of contacts on the first side to at least some of the gate electrodes and the source and drain regions and through the gate insulators and the source and drain insulators.

11. The method of claim 10, further comprising forming the gate electrodes, wherein a first of the transistor structures comprises a stack of nanoribbons extending through a first of the gate electrodes, and the forming the gate electrodes comprises depositing a metal to a first thickness between a surface of the first of the gate electrodes and a nearest of the nanoribbons to the surface and to a second thickness between the nearest of the nanoribbons and a next nearest of the nanoribbons to the surface, the surface of the first of the gate electrodes is opposite the metallization network and the second side, and the first thickness is greater than one-and-a-half times the second thickness.

12. The method of claim 11, further comprising revealing the gate electrodes on the first side of the substrate, wherein the revealing the gate electrodes exposes the surface and retains a third thickness of the gate electrode between the surface and the nearest of the nanoribbons, and the third thickness is less than or equal to the first thickness.

13. The method of any one of claims 10-12, wherein the first sacrificial material of the first rows and the second sacrificial material of the second rows comprise self-assembled monolayers of organic molecules, and the forming the alternating first and second rows comprises directed self-assembly.

14. The method of any one of claims 10-13, wherein the depositing the second dielectric layers contacts the second dielectric layers to fourth dielectric layers between the gate electrodes and the source and drain regions.

15. The method of any one of claims 10-14, wherein the metallization network on the second side of the substrate is a first metallization network, further comprising forming a second metallization network on the first side, the second metallization network coupled to the plurality of contacts on the first side and to the first metallization network on the second side.
